Europäisches Patentamt

European Patent Office

Office européen des brevets

(11) Publication number: **0 272 732 B1**

# EUROPEAN PATENT SPECIFICATION

(45) Date of publication of patent specification: **29.07.92**  (51) Int. Cl.⁵: **H01L  29/78**, G11C 17/00

(21) Application number: **87202392.4**

(22) Date of filing: **02.12.87**

(54) **Eeprom memory cell with a single level of polysilicon writable and cancellable bit by bit.**

(30) Priority: **22.12.86 IT 2280086**

(43) Date of publication of application:
**29.06.88 Bulletin  88/26**

(45) Publication of the grant of the patent:
**29.07.92 Bulletin  92/31**

(84) Designated Contracting States:
**DE FR GB NL**

(56) References cited:
**EP-A- 0 044 384**
**EP-A- 0 120 303**
**US-A- 4 019 197**

**ELECTRONICS, vol. 59, no. 30, 4th September 1986, page 30, New York, US; C.L. COHEN: "New memory-cell design may lower EPLD costs"**

(73) Proprietor: **SGS-THOMSON MICROELECTRON-ICS s.r.l.**
**Via C. Olivetti, 2**
**I-20041 Agrate Brianza Milano(IT)**

(72) Inventor: **Cappelletti, Paolo Giuseppe**
**C. so Garibaldi, 104**
**I-20030 Seveso (Milano)(IT)**
Inventor: **Corda, Giuseppe**
**Via Bergamo, 101**
**I-21047 Saronno (Varese)(IT)**
Inventor: **Riva, Carlo**
**Via S. Pellico, 24B**
**I-20052 Monza (Milano)(IT)**

(74) Representative: **Mittler, Enrico et al**
**c/o Marchi & Mittler s.r.l. Viale Lombardia, 20**
**I-20131 Milano(IT)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The present invention relates to an EEPROM memory cell with a single level of polysilicon which can be written and cancelled bit by bit.

There can be found in the literature several EEPROM cells with a single level of polysilicon which are written and cancelled by Fowler-Nordheim tunnel through a thin oxide or tunnel oxide, utilizing the capacitive couplings between the control gate, the floating gate and the semiconductor substrate.

These cells comprise a selection transistor, a detection transistor and a tunnel condensor formed by a thin oxide zone with implantation of $n^-$ phosphorous partially superimposed on the drain diffusion of the detection transistor. A single layer of polysilicon forms the gate of the selection transistor and, separately, an armature of the tunnel condenser and the floating gate of the detection transistor in a single piece with an armature of the coupling condenser of the control gate formed with an $n^+$ diffusion. Such cells can be found in EP-A-0 120 303 and in ELECTRONICS, vol. 59, no. 30, 4.Sept.1986, page 30, New York; C.L. COHEN: "New memory-cell design may lower EPLD costs".

Besides the benefit represented by the simplicity of the fabrication process resulting from the use of an $n^+$ diffusion as the control gate these known cells have the drawback of being writable bit by bit but cancellable by line (by writing is meant the subtraction of electrons from the floating gate and by cancellation the injection of electrons in said floating gate). This is due to the fact that the $n^+$ diffusion of the control gate is common to all the cells of a given memory line so that the cancellation order, represented by a high level of voltage applied to said $n^+$ diffusion, is automatically and unavoidably extended to all the cells which have the $n^+$ diffusion in common, i.e. to all the cells of a given line.

Considering this state of the art the object of the present invention is to accomplish an EEPROM memory cell with a single level of polysilicon which would be writable and cancellable by individual bits.

In accordance with the invention said object is achieved by an EEPROM memory cell comprising a selection transistor, a detection transistor with floating gate and control gate and a tunnel condenser with a thin oxide zone formed using a single layer of polysilicon for the gate of the selection transistor, the floating gate of the detection transistor and the tunnel condenser and an $n^+$ diffusion for the control gate characterized in that said $n^+$ diffusion is closed and isolated from that of the other cells of the same memory.

In this manner the cancellation order is applicable distinctly to the $n^+$ diffusion of each individual cell, which can then be cancelled bit by bit. Writing is similarly possible bit by bit, performed in the conventional manner by raising the level of the gate of the selection transistor of an entire memory line with the drain contacts to earth (or floating) for all the columns except that of the selected cell.

The characteristics of the present invention will be made clearer by the following detailed description of two possible forms of practical accomplishment thereof illustrated as nonlimiting examples in the annexed drawings wherein:

FIG. 1 shows a schematic plan view of a first EEPROM cell with a single level of polysilicon in accordance with the present invention,

FIG. 2 shows a cross section of said cell along line II-II of FIG. 1,

FIG. 3 shows a cross section of said cell along line III-III of FIG. 1, and

FIG. 4 shows a schematic plan view of a second EEPROM cell with a single level of polysilicon in accordance with the present invention.

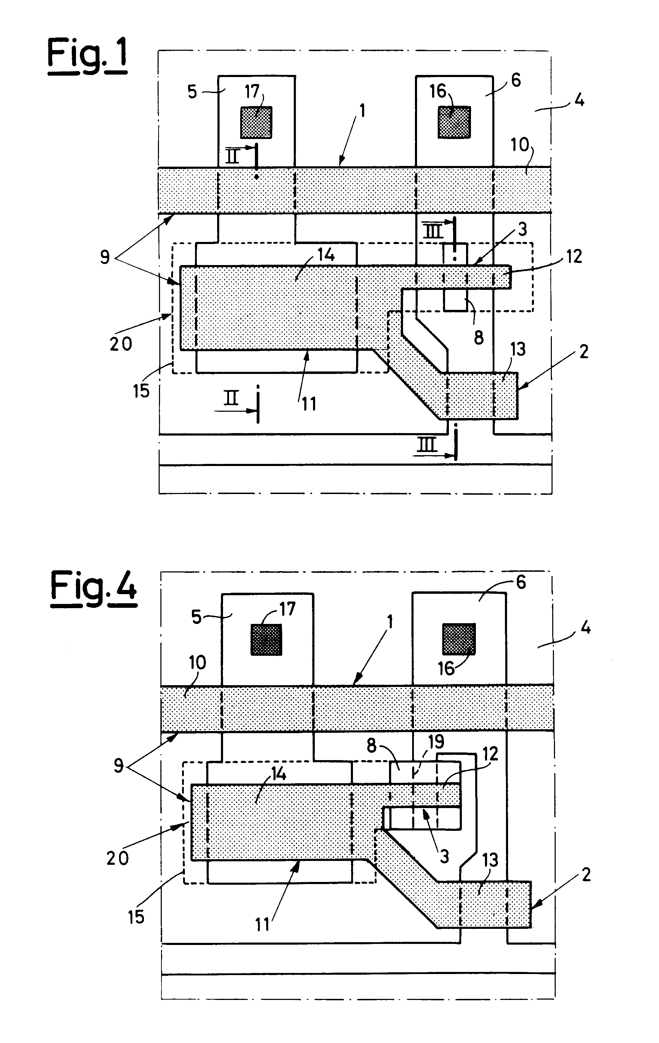

With reference to FIGS. 1-3 there is shown an EEPROM memory cell in accordance with the invention which comprises a selection transistor 1, a detection transistor 2 and a tunnel condenser 3.

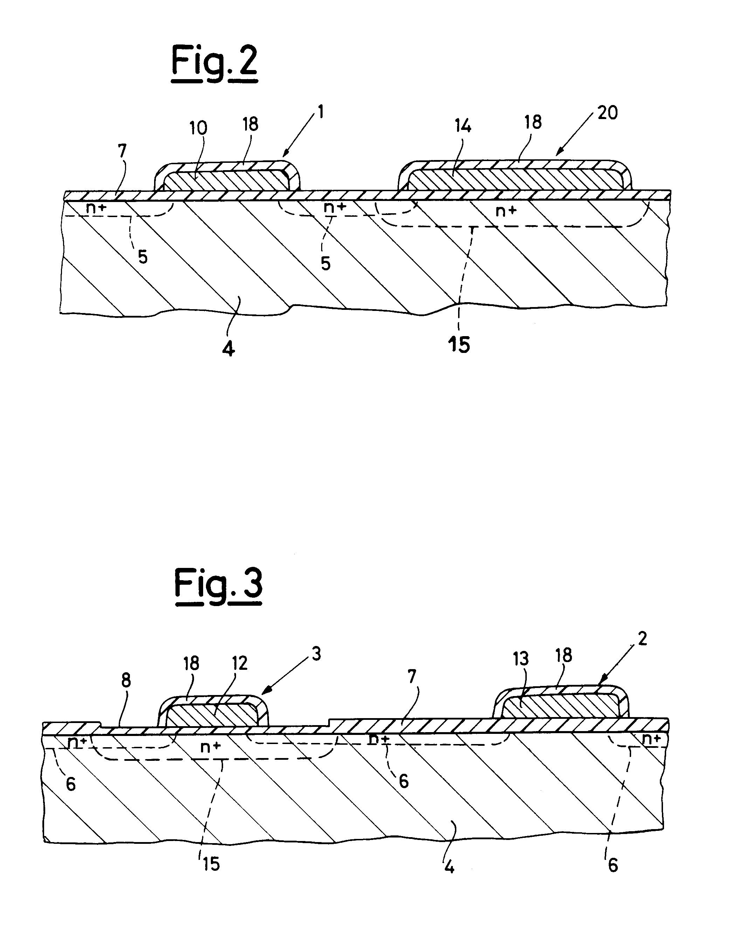

More specifically, on a semiconducting substrate 4 are provided two active areas with $n^+$ diffusion 5 and 6. On the structure is grown gate oxide 7 (FIGS. 2 and 3) including a thin oxide zone 8 on the active area 6. A single polysilicon layer 9 further superimposed is formed by a straight strip 10 which forms the gate of the selection transistor 1 and by a U part 11 which has a first branch placed on the thin oxide zone 8 and hence on the active area 6 to form the tunnel condenser 3, a second branch 13 placed similarly on the active area 6 to form the floating gate of the detection transistor 2 and a connection space 14 placed on the active area 5 to form together with an underlying $n^+$ diffusion 15 the control gate 20 of the detection transistor 2. As may be seen in FIG. 1 the $n^+$ diffusion 15 is closed and isolated as regards those of the other cells of the same memory. Reference number 16 indicates a drain contact while reference number 17 indicates an output contact. Further oxide 18 is superimposed on the layer of polysilicon 9 (FIGS. 2 and 3).

In operation, writing (i.e. the extraction of electrons from the floating gate 13 of the detection transistor 2) is performed by bringing to high level the gate 10 of the selection transistor 1 with all the drain contacts 16 earthed (or floating) except those of the cells of the column to which belongs the selected cell. Writing is then performed by individual bit.

Cancellation (i.e. injection of electrons in the floating gate 13 of the detection transistor 2) is in turn performed by bringing to a high level the gate 10 of the selection transistor 1 and the contact 17 of the column to which belongs the selected cell so as to bring the n$^+$ diffusion to correspondingly high level. The latter being closed and isolated, cancellation is also performed bit by bit.

Essentially similar is the structure of the other cell in accordance with the invention, which is illustrated in FIG. 4. The only difference is that this time the tunnel condenser 3 is made at the crossing of the polysilicon branch 12 with a branch 19 of the active area 6 where the thin oxide zone 8 is provided.

The manner of operation of the cell of FIG. 4 is identical to that already described for the cell of FIGS. 1-3.

## Claims

1. EEPROM memory cell comprising a selection transistor (1), a detection transistor (2) with floating gate (13) and control gate (20) and a tunnel condenser (3) with a thin oxide zone (8) formed using a single layer of polysilicon (9) for the gate (10) of the selection transistor (1), the floating gate (13) of the detection transistor (2) and the tunnel condenser (3) and an n$^+$ diffusion (15) for the control gate (20) characterized in that said n$^+$ diffusion (15) is closed and isolated from that of the other cells of the same memory.

2. Memory cell in accordance with claim 1 characterized in that said single layer of polysilicon (9) comprises a first straight strip part (10) forming the gate of the selection transistor (1) and a second part (11) formed of a first branch (12) superimposed on the thin oxide zone (8) on a first active area (6) of a semiconductor substrate (4) to form the tunnel condenser (3), a second branch (13) superimposed on said first active area (6) to form the floating gate of the detection transistor (2) and a space (14) superimposed on said n$^+$ diffusion (15) on a second active area (5) of said substrate (4) to form the control gate (20) of the detection transistor (2).

3. Memory cell in accordance with claim 2 characterized in that said thin oxide zone (8) is formed of a branch (19) of said first active area (6).

## Revendications

1. Cellule mémoire EEPROM, comprenant un transistor de sélection (1), un transistor de détection (2) muni d'une grille flottante (13) et d'une grille de commande (20) et un condensateur tunnel (3) muni d'une zone d'oxyde mince (8), formée en utilisant une couche unique de silicium polycristallin (9) pour la grille (10) du transistor de sélection (1), la grille flottante (13) du transistor de détection (2) et le condensateur tunnel (3), et une diffusion N$^+$ - (15) pour la grille de commande (20), caractérisée en ce que la diffusion N$^+$ (15) est fermée et isolée de celles des autres cellules de la même mémoire.

2. Cellule mémoire selon la revendication 1, caractérisée en ce que la couche unique de silicium polycristallin (9) comprend une première partie de bande droite (10) formant la grille du transistor de sélection (1) et une seconde partie (11) formée d'une première branche (12) superposée à la zone d'oxyde mince (8) sur une première zone active (6) d'un substrat semiconducteur (4) pour former le condensateur tunnel (3), d'une seconde branche (13) superposée à la première zone active (6) pour former la grille flottante du transistor de détection (2) et d'un espace (14) superposé à la diffusion N$^+$ (15) sur une seconde zone active (5) du substrat (4) pour former la grille de commande (20) du transistor de détection (2).

3. Cellule mémoire selon la revendication 2, caractérisée en ce que la zone d'oxyde mince (8) est constituée d'une branche (19) de la première zone active (6).

## Patentansprüche

1. EEPROM-Speicherzelle, aufweisend einen Auswähltransistor (1), einen Detektionstransistor (2) mit einem schwimmenden Gate (13) und einem Steuergate (20), und einen Tunnelkondensator (3) mit einer dünnen Oxidzone (8), wobei die EEPROM-Speicherzelle unter Verwendung einer einzelnen Polysiliziumschicht (9) für das Gate (10) des Auswähltransistors (1), für das schwimmende Gate (13) des Detektionstransistors (2) und für den Tunnelkondensator (3) und einer n$^+$-Diffusion (15) für das Steuergate (20) gebildet ist, **dadurch gekennzeichnet,** daß die n$^+$-Diffusion (15) gegenüber derjenigen der anderen Zellen desselben Speichers abgeschlossen und getrennt ist.

2. Speicherzelle nach Anspruch 1, **dadurch gekennzeichnet,** daß die einzelne Polysiliziumschicht (9) einen das Gate des Auswähltransistors (1) bildenden geraden streifenförmigen ersten Teil (10) aufweist und einen zweiten Teil, gebildet aus einem zum Bilden des Tunnelkondensators (3) der dünnen Oxidzone (8) auf einem ersten aktiven Bereich (6) eines Halbleitersubstrates (4) überlagerten ersten Zweig (12), aus einem zum Bilden des schwimmenden Gates des Detektionstransistors (2) dem ersten aktiven Bereich (6) überlagerten zweiten Zweig (13) sowie aus einer der $n^+$-Diffusion (15) auf einem zweiten aktiven Bereich (5) des Substrates (4) zum Bilden des Steuergates (20) des Detektionstransistors (2) überlagerten Fläche.

3. Speicherzelle nach Anspruch 2, **dadurch gekennzeichnet,** daß die dünne Oxidzone (8) aus einem Zweig (19) des ersten aktiven Bereiches (6) gebildet ist.

## Fig.1

## Fig.4

# Fig.2

# Fig.3